# EUROPEAN PATENT APPLICATION

(11) **EP 3 349 296 A1**
(43) Date of publication of application: **18.07.2018**
(21) Application number: 15834631.2
(22) Date of filing: 08.09.2015
(51) Int. Cl.: H01M 10/42, H01M 2/10, H01M 10/48

(54) **STORAGE BATTERY DEVICE, STORAGE BATTERY SYSTEM, METHOD, AND PROGRAM**

(71) Applicant: Kabushiki Kaisha Toshiba, Minato-ku Tokyo 105-8001 (JP)
(72) Inventor: SAKATA, Yasuji, Tokyo 105-8001 (JP); MIZUTANI, Mami, Tokyo 105-8001 (JP); KOBAYASHI, Takenori, Tokyo 105-8001 (JP); TOYOSAKI, Tomohiro, Tokyo 105-8001 (JP)
(74) Representative: AWA Sweden AB
(86) International application number: PCT/JP2015/075512
(87) International publication number: WO 2017/042892

(57) **Abstract**

A storage battery device of an embodiment is a storage battery device in which a plurality of battery boards are connected in parallel, the battery board including a plurality of cell modules connected in series, and the cell module including a battery cell, including a performance value acquisition unit that acquires a performance value of the cell module, and an information generator that generates rearrangement information, the rearrangement information being for performing rearrangement of the cell module between the plurality of battery boards based on the acquired performance value of the cell module to reduce a variation in the performance value of the cell module after being rearranged in one battery board than before being rearranged. Therefore, a work space, a work labor, and work hour can be saved in the rearrangement work of the battery modules.

## Description

### FIELD

Embodiments of the present invention relate to a storage battery device, a storage battery system, a method, and a program.

### BACKGROUND

In recent years, there is developed a secondary battery which has a high energy density and a long lifespan such as a lithium ion battery. The secondary battery is widely used not only as an on-vehicle secondary battery but also as a stationary storage battery aimed at stabilizing a power system. An expected life span of a stationary storage battery system is long enough 15 to 20 years, but the life span of the secondary battery varies depending on a usage type and an ambient environment. Therefore, there are concerns about that the degree of progressed degradation of the battery is not even, and the degradation of the battery is rapidly progressed. In addition, it may be considered that the degree of progressed degradation of the battery varies due to a variation in performance of battery cells. Specifically, in a large-scaled storage battery system using the lithium ion battery, a number of battery cells are combined in series/parallel in a multiple manner to establish a large-output/large-capacity storage battery.

In this case, when a variation in degradation occurs between the battery cells, the performance of the entire storage battery system may be remarkably decreased.

In other words, in a battery pack forming the stationary storage battery system, when the variation in degradation occurs between the respective battery modules (or the battery cells) in a battery module group (battery unit) connected in series, the performance of the entire battery module group is determined by a most-degraded battery module (or a battery cell), and thereby the performance is remarkably decreased.

There is proposed a technique in which the battery modules are sorted according to the degradation state to recover the entire performance in a case where the variation in degradation occurs between the respective battery modules (see Patent Literatures 1 and 2).

### CITATION LIST

### Patent Literature

Patent Literature 1: Japanese Laid-open Patent Publication No.2014-127404
Patent Literature 2: Japanese Laid-open Patent Publication No.2014-075317
Patent Literature 3: Japanese Laid-open Patent Publication No.2014-119397
Patent Literature 4: Japanese Laid-open Patent Publication No.2014-023362
Patent Literature 5: Japanese Laid-open Patent Publication No.2014-041747
Patent Literature 6: Japanese Laid-open Patent Publication No.2014-110198
Patent Literature 7: Japanese Laid-open Patent Publication No.2015-008040
Patent Literature 8: Japanese Laid-open Patent Publication No.2013-137867

### SUMMARY OF THE INVENTION

### Problem to be Solved by the Invention

However, these well-known techniques propose a method in which all the battery modules are sorted and rearranged according to the degradation state of the respective battery modules. Therefore, a wide work space is necessarily secured for exchanging the battery modules, and it takes large work load and time.

The invention has been made in view of the problems, and an object thereof is to provide a storage battery device, a storage battery system, a method, and a program through which the work space, the work load, and the work time can be reduced at the time of rearrangement work of the battery modules.

### Means for Solving Problem

The storage battery device of an embodiment is a storage battery device in which battery cells are connected in series.

Then, each battery cell is connected in parallel to a bypass circuit which includes a diode reversely connected with respect to the corresponding battery cell and a current limiting element connected in series to the diode.

### BRIEF DESCRIPTION OF DRAWINGS

FIG. 1 is a diagram schematically illustrating a configuration of a natural energy power generation system which includes a storage battery system of an embodiment.
FIG. 2 is a block diagram schematically illustrating a configuration of the storage battery system of the embodiment.
FIG. 3 is a diagram for describing a configuration of a cell module, a CMU, and a BMU in detail.
FIG. 4 is a diagram for describing a performance of a battery board unit in a case where the cell modules are equal in performance.
FIG. 5 is a diagram for describing the performance of the battery board unit in a case where a variation occurs in the performance of the cell module.
FIG. 6 is a flowchart illustrating a process of calculating and presenting rearrangement information.
FIG. 7 is a diagram (Part 1) for describing a rearrangement destination setting sequence.
FIG. 8 is a diagram (Part 2) for describing the rearrangement destination setting sequence.
FIG. 9 is a diagram (Part 3) for describing the rearrangement destination setting sequence.
FIG. 10 is a diagram for describing arrangement positions of the cell modules after the rearrangement is completed.
FIG. 11 is a diagram for describing a performance of the battery board unit after the cell modules are rearranged.

### DETAILED DESCRIPTION

Next, embodiments will be described with reference to the drawings.

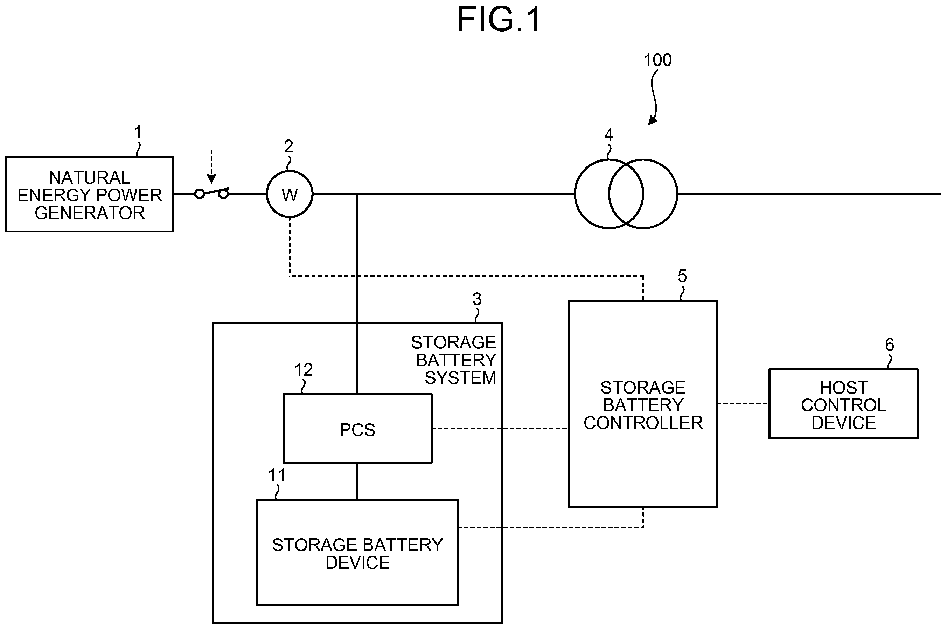

FIG. 1 is a diagram schematically illustrating a configuration of a natural energy power generation system which includes a storage battery system of an embodiment.

A natural energy power generation system 100 includes a natural energy power generator 1 which serves as a power system and can output system power using natural energy (renewable energy) such as solar power, water power, wind power, biomass power, or geothermal power, a power meter 2 which measures the generated power of the natural energy power generator 1, a storage battery system 3 which charges surplus power of the natural energy power generator 1 based on the measurement result of the power meter 2 and discharges/outputs power in proportion to insufficient power together with the generated power of the natural energy power generator 1 in an overlapping manner, a transformer 4 which converts a voltage of the output power (including a case where the output power of the storage battery system 3 is overlapped) of the natural energy power generator 1, a storage battery controller 5 which locally controls the storage battery system 3, and a host control device 6 which remotely controls the storage battery controller 5.

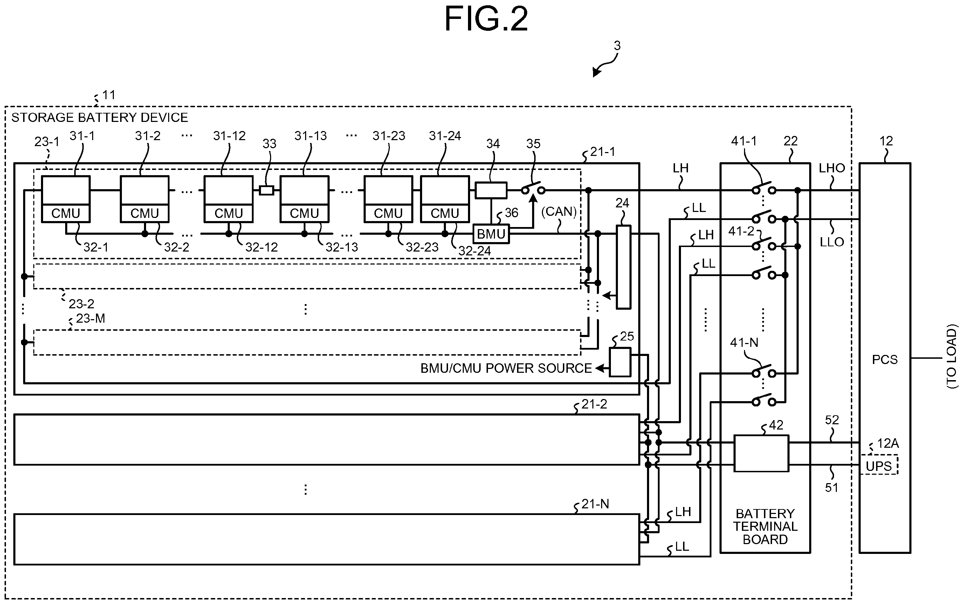

FIG. 2 is a block diagram schematically illustrating a configuration of the storage battery system of the embodiment.

The storage battery system 3 comprises, when it is roughly classified, a storage battery device 11 which accumulates power and a power conditioning system (PCS) 12 which converts a DC power supplied from the storage battery device 11 into an AC power of a desired power quality and supplies the AC power to a load.

The storage battery device 11 includes, when it is roughly classified, a plurality of battery board units 21-1 to 21-N (N is a natural number) and a battery terminal board 22 to which the battery board units 21-1 to 21-N are connected.

Each of the battery board units 21-1 to 21-N includes a plurality of battery boards 23-1 to 23-M (M is a natural number) which are connected to each other in parallel, a gateway unit 24, and a DC power source 25 which supplies DC power to a BMU (Battery Management Unit) and a CMU (Cell Monitoring Unit), which will be described below, for the operation thereof.

Herein, a configuration of a battery unit will be described.

Each of the battery boards 23-1 to 23-M is connected to output power lines (bus bars) LHO and LLO through a power supply line LH on a high potential side and a power supply line LL on a low potential side, and supplies the power to the power conditioning system 12 that is a main circuit.

Since the battery boards 23-1 to 23-M have the same configuration, only the battery board 23-1 will be described.

The battery board 23-1 includes, when it is roughly classified, a plurality of cell modules 31-1 to 31-24 (24 modules in FIG. 1), a plurality of CMUs 32-1 to 32-24 (24 CMUs in FIG. 1) which are respectively connected to the cell modules 31-1 to 31-24, a service disconnector 33 which is provided between the cell module 31-12 and the cell module 31-13, a current sensor 34, and a connector 35, and the plurality of cell modules 31-1 to 31-24, the service disconnector 33, the current sensor 34, and the connector 35 are connected in series.

Herein, the cell modules 31-1 to 31-24 form a battery pack in which a plurality of battery cells are connected in series/parallel. Then, a battery pack group is formed of the plurality of cell modules 31-1 to 31-24 which are connected in series.

Furthermore, the battery board 23-1 comprises a BMU 36, and a communication line of each of the CMUs 32-1 to 32-24 and an output line of the current sensor 34 are connected to the BMU 36.

The BMU 36 controls the entire battery board 23-1 under the control of the gateway unit 24, and performs a switching control of the connector 35 based on a communication result (voltage data and temperature data described below) of each of the CMUs 32-1 to 32-24 and a detection result of the current sensor 34.

Next, a configuration of the battery terminal board will be described.

The battery terminal board 22 comprises a plurality of board breakers 41-1 to 41-N which are provided in correspondence to the battery board units 21-1 to 21-N, and a master unit 42 which is a microcomputer for controlling the entire storage battery device 11.

The master unit 42 is connected to the power conditioning system 12 through a control power line 51 which is supplied from a UPS (Uninterruptible Power System) 12A of the power conditioning system 12 and a control communication line 52 which is formed by Ethernet (registered trademark) and exchanges control data.

Herein, the configuration of the cell modules 31-1 to 31-24, the CMUs 32-1 to 32-24, and the BMU 36 will be described.

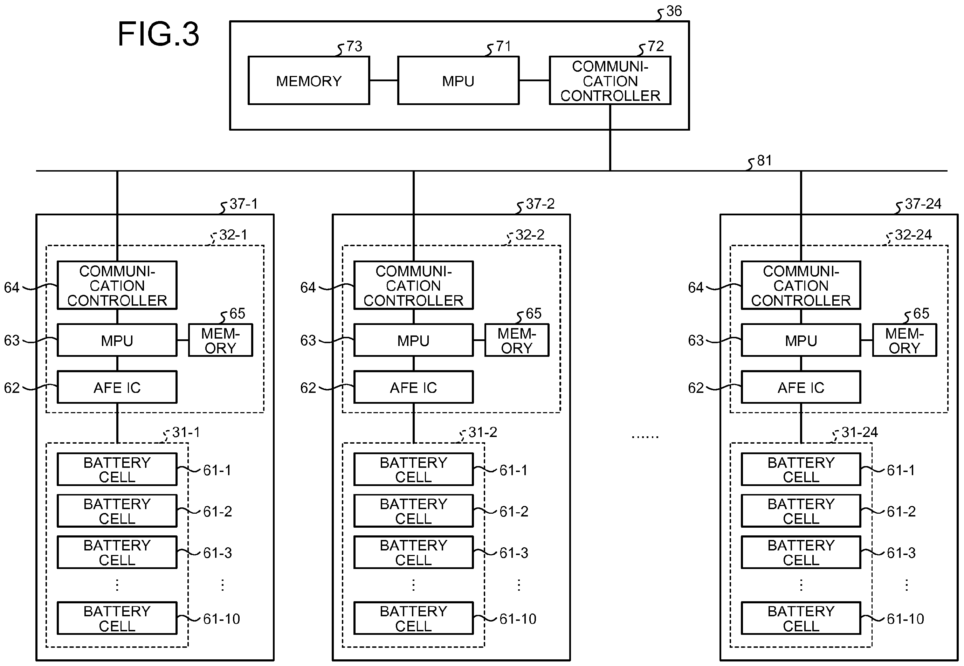

FIG. 3 is a diagram for describing the configuration of the cell module, the CMU, and the BMU in detail.

Each of the cell modules 31-1 to 31-24 comprises a plurality of battery cells 61-1 to 61-10 (10 battery cells in FIG. 3) which are connected in series.

Each of the CMUs 32-1 to 32-24 comprises an analog front end IC (AFE-IC) 62 which is used to measure a voltage of the corresponding one of the cell modules 31-1 to 31-24 and a temperature of a predetermined module, an MPU 63 which controls the entire corresponding CMUs 32-1 to 32-24, a communication controller 64 which is in conformity to a CAN (Controller Area Network) standard for CAN communication with the BMU 36, and a memory 65 which stores the voltage data corresponding to the voltage and the temperature data for each cell.

In the following description, the configuration in which each of the cell modules 31-1 to 31-24 and the corresponding one of the CMUs 32-1 to 32-24 are contained will be called battery modules 37-1 to 37-24. For example, the configuration in which the cell module 31-1 and the corresponding CMU 32-1 are contained will be called the battery module 37-1.

In addition, the BMU 36 comprises an MPU 71 which controls the entire BMU 36, a communication controller 72 which is used for the CAN communication with the CMUs 32-1 to 32-24 in conformity to the CAN standard, and a memory 73 which stores the voltage data and the temperature data transmitted from the CMUs 32-1 to 32-24.

The storage battery controller 5 detects the generated power of the natural energy power generator 1, and suppresses the generated power output from being fluctuated using the storage battery device 11 in order to alleviate an influence of the generated power on the power system. Herein, the suppressed fluctuation amount with respect to the storage battery device 11 is calculated by the subject storage battery controller 5 or the host control device 6, and is given to the PCS (Power Conditioning System) 12 corresponding to the storage battery device 11 as a charge/discharge command.

Next, before starting the description about the operation of the embodiment, the storage battery system using a lithium ion battery will be given as an example for describing a degradation phenomenon of a typical storage battery.

There are exemplified an internal resistance and a battery capacity as battery characteristics changed along with degradation. The battery capacity has a decrease tendency with time and, on the contrary, the internal resistance of the battery has an increase tendency. An increase of the internal resistance is exemplified as one of factors causing the decrease of the battery capacity.

In addition, a degradation speed of the battery generally becomes large as a temperature of the battery is increased. Therefore, when a variation in temperature occurs in the battery board, the degradation is easily progressed in a module containing a high-temperature battery. For example, the battery is heated as being charged or discharged, and the temperature of the battery is increased. The heat generated from the battery is collected in the upper portion of the battery board, and the temperature of the battery tends to be increased as the battery is positioned on the higher portion. In addition, the temperature of the battery board may be increased by the heat generated and exhausted from an adjacent machine such as the PCS. In this way, when the variation in temperature occurs in the battery board, the degradation of the high-temperature battery cell and the battery module will be a cause for concern.

Herein, since the storage battery system 3 includes the battery pack where the battery cells 61-1 to 61-10 and the cell modules 31-1 to 31-24 are combined in series/parallel in a multiple manner, the variation in degradation state may occur among the battery cells 61-1 to 61-10 and the cell modules 31-1 to 31-24.

When viewing the battery cells 61-1 to 61-10 connected in series in the cell modules 31-1 to 31-24, the capacity (Ah: Ampere per Hour) of each of the cell modules 31-1 to 31-24 is defined by a minimum capacity in the battery cells 61-1 to 61-10 contained in each of the cell modules 31-1 to 31-24. For example, when the full charging is performed after the full discharging based on a maximum capacity of the battery cell (for example, the battery cell 61-10), the other battery cells (the battery cells 61-1 to 61-9 in the above case) are over-discharged or over-charged.

Similarly, when viewing the cell modules 31-1 to 31-24 connected in series in the battery boards 23-1 to 23-M, the capacity (Ah) of each of the battery boards 23-1 to 23-M is defined by a minimum capacity in the cell modules 31-1 to 31-24 contained in each of the battery boards 23-1 to 23-M. For example, when the full charging is performed after the full discharging based on a maximum capacity of the cell module (for example, the cell module 31-1), the other cell modules (the cell modules 31-2 to 31-24 in the above case) are over-discharged or over-charged.

In other words, the performance of the battery cell or the cell module having the lowest performance in the series configuration determines the performance of the entire series configuration.

On the contrary, when viewing the battery boards 23-1 to 23-M connected in parallel, the capacity of each of the battery board units 21-1 to 21-N is the sum of capacities of the battery boards 23-1 to 23-M (at least statically).

Furthermore, the capacity of the entire storage battery device 11 is the sum of the capacities of the battery board units 21-1 to 21-N (at least statically).

Therefore, the performance degradation of the storage battery device 11 will be modeled using the battery board unit 21-1.

In addition, in order to help with understanding and for the sake of simplicity in the description, it is assumed that the battery board unit 21-1 comprise three battery boards 23-1 to 23-3, and each of the battery boards 23-1 to 23-3 includes three cell modules 31-1 to 31-3.

In the following description, for making an identification between the cell modules 31-1 to 31-3 of each of the battery boards 23-1 to 23-3, the cell modules 31-1 to 31-3 of the battery board 23-1 are illustrated as cell modules C1 to C3, the cell modules 31-1 to 31-3 of the battery board 23-2 are illustrated as cell modules C4 to C6, and the cell modules 31-1 to 31-3 of the battery board 23-3 are illustrated as cell modules C7 to C9.

In other words, the battery board unit 21-1 is configured by nine cell modules C1 to C9 in total.

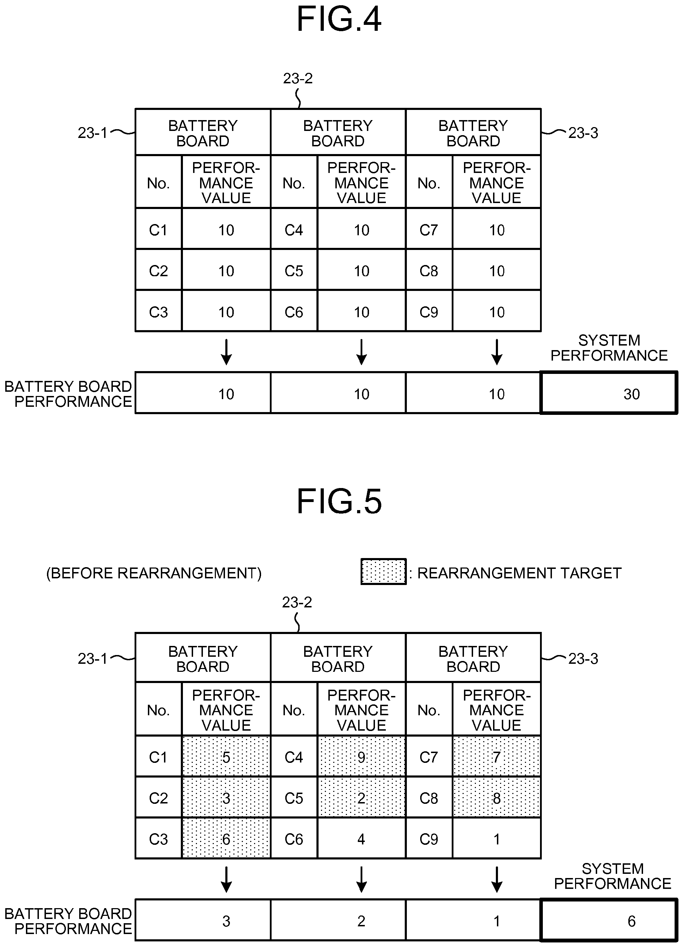

FIG. 4 is a diagram for describing the performance of the battery board unit in a case where the cell modules are equal in performance.

A performance value assigned to each of the cell modules C1 to C9 indicates, for example, a degradation state of each of the cell modules C1 to C9 based on a result of the internal resistance measured with respect to the battery cells (the battery cells 61-1 to 61-9) of each cell module or the cell modules C1 to C9.

In general, the internal resistance is increased as the degradation of a secondary battery is progressed, and a chargeable/dischargeable capacity is reversely decreased.

The performance values of the cell modules C1 to C9 illustrated in FIG. 4 simply indicate the degradation of the battery calculated in 10 different steps based on the internal resistance of the cell modules C1 to C9 and the capacity of the battery cells of each of the cell modules C1 to C9. In other words, the degradation becomes less as the performance value is increased (as the value approximates to 10 in the case of FIG. 4).

By the way, the performance of each of the battery boards 23-1 to 23-3 is determined by a minimum value in the performance values corresponding to three cell modules connected in series. On the other hand, the performance of the entire battery board unit 21-1 becomes the summation value of the performance values of the battery boards 23-1 to 23-3.

FIG. 4 illustrates a state in which the battery board unit 21-1 in a case where the performances of the cell modules C1 to C9 are equal (there is no variation in the performance value of the cell module) and the performance is high (for example, an initial state) is considered.

In the case of the example of FIG. 4, the performance value of the entire battery board 23-1 becomes 30 (= 10 + 10 + 10). Similarly, the performance value of the entire battery board 23-2 becomes 30 (= 10 + 10 + 10), and the performance value of the entire battery board 23-3 becomes 30 (= 10 + 10 + 10).

FIG. 5 is a diagram for describing the performance of the battery board unit in a case where the variation occurs in the performance of the cell module.

By the way, the secondary battery of the battery cells 61-1 to 61-10 is progressively degraded by charge/discharge cycles and a secular change, but a degradation degree is different depending on a usage situation and an ambient environment (temperature, humidity). Therefore, it cannot be said that the respective cell modules C1 to C9 are uniformly degraded.

For example, as illustrated in FIG. 5, in a case where the variation occurs in the performance values of the cell modules C1 to C9 of the battery board unit 21-1, even when there is a cell module having a high performance value, the performances of the battery boards 23-1 to 23-3 are determined by a minimum value in the performance values corresponding to three cell modules connected in series. Therefore, the performance value of the entire battery board unit 21-1 is decreased to 6 (= 3 + 2 + 1).

In this way, in the battery board unit 21-1 of which the variation in the performance values of the cell modules C1 to C9 is found out, the performance of each of the battery boards 23-1 to 23-3 is improved (recovered) by changing the arrangement of the cell modules C1 to C9, and furthermore the performance of the battery board unit 21-1 can be improved (recovered).

In other words, as described above, in the cell module group connected in series, the cell module (or the battery cell) having the lowest performance value becomes a restriction, and the chargeable/dischargeable capacity is determined.

On the other hand, in a case where the variation in the performance occurs between the battery boards 23-1 to 23-3 connected in parallel, the capacity of the battery board unit 21-1 becomes the sum of the capacities of the battery boards 23-1 to 23-3.

For this reason, the influence of the variation in the performance values of the cell modules C1 to C9 is decreased in the case of the parallel connection compared to the case of the series connection. Strictly speaking, in a case where an internal resistance difference occurs between the battery boards 23-1 to 23-3 connected in parallel, charging/discharging currents flowing in the respective battery boards 23-1 to 23-3 become unequal, an SOC is changed, and behaviors of these factors become significantly complicated.

Therefore, the chargeable/dischargeable capacity tends to be decreased when being compared to a case where the capacities of the respective battery boards 23-1 to 23-3 are simply summated, but the influence is considered to be less when being compared to a case where the performance difference occurs between the cell modules C1 to C9 connected in series.

Therefore, when the cell modules are rearranged to suppress a difference in the performance between the cell modules C1 to C9 connected in series, it is possible to improve (recover) the decrease in the capacity of each of the battery boards 23-1 to 23-3 as well as the battery board unit 21-1.

In other words, in this embodiment, the cell modules C1 to C9 are optionally arranged in the battery boards 23-1 to 23-3, and the cell modules C1 to C9 are rearranged to minimize the difference in the performance values of the cell modules of each of the battery boards 23-1 to 23-3, so that the performances of the respective battery boards 23-1 to 23-3 are improved (recovered) with a minimum labor. Therefore, the capacity (performance) of the battery board unit 21-1 (that is, the system performance) is improved (recovered).

Next, a sequence of calculating and presenting rearrangement information for performing rearrangement of the cell modules based on the performance values of the respective cell modules will be described. The following description will be made about a case where the calculation and the presentation of the rearrangement information are performed by the host control device 6.

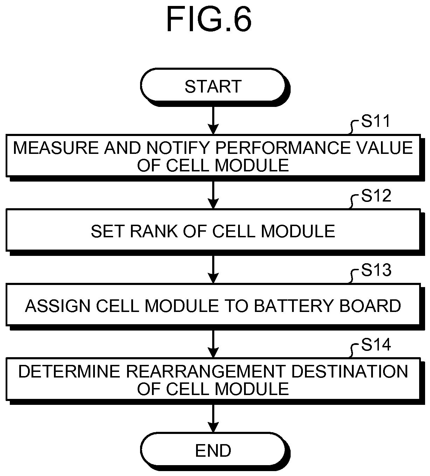

FIG. 6 is a flowchart of a process of calculating and presenting the rearrangement information.

First, the host control device 6 causes the CMUs 32-1 to 32-24 to measure or estimate the internal resistances or the battery capacities of the battery cells of the cell modules 31-1 to 31-24 through the storage battery controller 5, the PCS 12, and the BMU 36 of the battery boards 23-1 to 23-M of each of the battery board units 21-1 to 21-N, and to acquire the performance values of the respective cell modules 31-1 to 31-24 and notify the performance values (step S11).

Next, the host control device 6 assigns an order of the cell modules based on the performance values of the respective cell modules notified through the BMU 36 of the battery boards 23-1 to 23-M of each of the battery board units 21-1 to 21-N, the PCS 12, and the storage battery controller 5 (step S12).

Specifically, a higher order is set to a higher performance value. In the case of the example of FIG. 5, the order is assigned such that the cell module C1 is at a fifth rank, the cell module C2 is at a seventh rank, the cell module C3 is at a fourth rank, the cell module C4 is at a first rank, the cell module C5 is at an eighth rank, the cell module C6 is at a sixth rank, the cell module C7 is at a third rank, the cell module C8 is at a second rank, and the cell module C9 is at a ninth rank.

Next, the host control device 6 collectively assigns the battery boards 23-1 to 23-3 with a maximum number of cell modules arrangeable to each of the battery boards 23-1 to 23-3 in the order determined in step S12 (step S13).

Specifically, for example, the battery board 23-1 is assigned with the cell modules (the cell modules C4, C8, and C7) of which the performance values correspond to the first to third ranks, the battery board 23-2 is assigned with the cell modules (the cell modules C3, C1, and C6) of which the performance values correspond to the fourth to sixth ranks, and the battery board 23-3 is assigned with the cell modules (the cell modules C2, C5, and C9) of which the performance values correspond to the seventh to ninth ranks.

Therefore, the difference in the performances of the cell modules after being assigned to each of the battery boards 23-1 to 23-3 becomes small compared to the state before the assignment, and the capacity actually unused in charging/discharging is reduced.

Next, the host control device 6 determines a specific rearrangement destination of the cell module (step S14) .

In this case, since the arrangement of the cell modules (a series connection order) in each of the battery boards 23-1 to 23-3 can be optionally set without an influence on the performance of the corresponding one of the battery boards 23-1 to 23-3, the cell modules (the cell module C6 and the cell module C9 in the case of the example of FIG. 5) of which the corresponding battery board is not changed before and after the assignment are excluded from the rearrangement target but left as it is. Therefore, it is possible to recover the performance of the entire storage battery system while reducing a labor over the exchange of the battery modules.

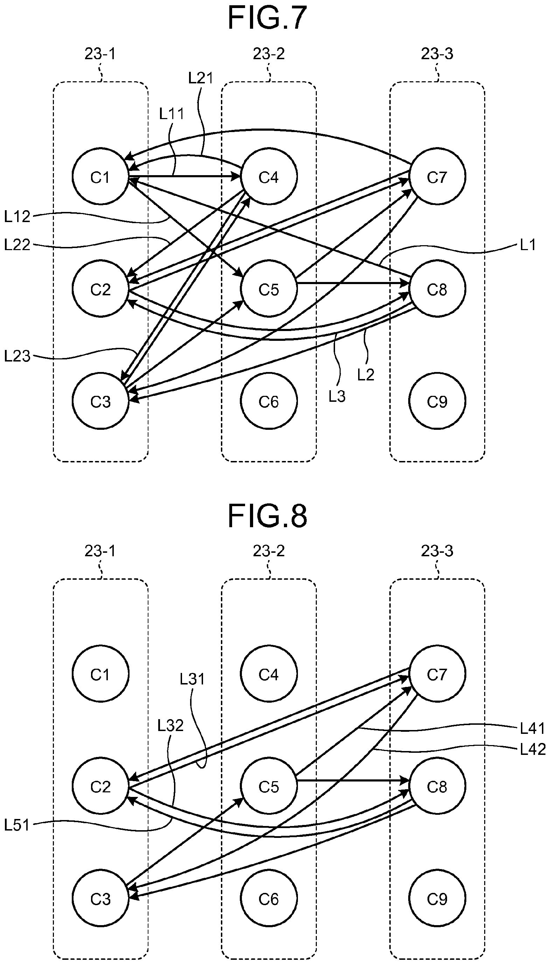

FIG. 7 is a diagram (Part 1) for describing a rearrangement destination setting sequence.

For example, the cell module C1 is arranged in the battery board 23-1 before the rearrangement, but is necessarily arranged in the battery board 23-2 after the rearrangement.

Herein, since the cell module C6 arranged in the battery board 23-2 of the rearrangement destination is excluded from the rearrangement target as described above, only the cell module C4 or the cell module C5 of the battery board 23-2 before the rearrangement becomes the rearrangement destination of the cell module C1.

Similarly, in FIG. 7, an algorithm of a shortest route problem of graph theory is applied to each of the cell modules C1 to C5 and C7 to C8 of all the rearrangement targets, the arrangement position of each cell module is set as a node, and a moving direction from the original arrangement position (node) to the rearrangement destination is indicated as a directed side (arrow). In other words, each cell module is actually moved in the route along the directed side only once at the time of the rearrangement, but there may be one or plural rearrangement positions in consideration of rearrangement destinations (rearrangement positions).

For example, since the cell module C8 is arranged in the battery board 23-3 before the rearrangement, but is necessarily arranged in the battery board 23-1 after the rearrangement, the cell module C8 can be rearranged at the arrangement positions of the cell modules C1 to C3 of the battery board 23-1 before the rearrangement. Therefore, three directed sides L1 to L3 are indicated in FIG. 7.

Next, the host control device 6 determines a rearrangeable position by obtaining the shortest route (the shortest closed route) through which each of the cell modules C1 to C5 and C7 to C8 of all the rearrangement targets is returned to the arrangement position of the original cell module via at least other one cell module along the directed sides indicated by arrows in FIG. 7 (step S14).

In other words, the rearrangeable position is determined while suppressing the cell module at the least movement. More specifically, in a case where the rearrangement of two cell modules is completed by the movement (that is, exchanging of arrangement positions) of the two cell modules when the cell module of one rearrangement target is rearranged, the rearrangeable position is employed in priority over a rearrangeable position where the rearrangements of three cell modules are completed by the movement of the three cell modules.

This is because the case where the rearrangements of the two cell modules are completed by the movement of the two cell modules is applied on a less work load.

Subsequently, the determination of the rearrangement destination will be described in more detail with reference to the directed graph illustrated in FIG. 7.

As also described above, since the cell module C6 and the cell module C9 are the cell modules having no need to move in FIG. 7, there is no effective side indicating the movement destination of the cell module.

Then, the rearrangement position of the battery module is determined using the directed graph illustrated in FIG. 7 by obtaining the shortest route (shortest closed route) through which each cell module is returned from the original arrangement position (node) of the cell module of an examination target of the rearrangement destination to the original arrangement position (node) of the cell module of the original examination target via the arrangement position (node) of at least other one cell module.

In this case, a rearrangement (movement) cost due to a wrong rearrangement destination of the cell module (that is, all of the exchanging labors such as the excluding of the cell module, the movement of the cell module, and the installation of the cell module) is assumed to be equal, and the weights of the effective sides are all set to "1". Further, in a case where the exchanging labor is likely to be significantly changed by the rearrangement destination (movement destination), the weight of the effective side corresponding to the subject rearrangement may be increased to set the rearrangement destination in consideration of the rearrangement cost in order to take the exchanging labor into consideration.

In an actual process, in a network in which the candidates of the rearrangement positions of the cell modules C1 to C9 are expressed by a directed graph, the shortest route may be deprived using an algorithm for solving the shortest route problem such as the Dijkstra method or the Bellman-Ford method.

First, in FIG. 7, the rearrangement destination of the cell module C1 at the current arrangement position (a first node) is obtained. As the candidates of the rearrangement destination of the cell module C1, there are indicated the directed sides L11 and L12 toward the arrangement position (a fourth node) of the cell module C4 and the arrangement position (a fifth node) of the cell module C5.

However, since the cell module C4 is a cell module to be rearranged to the battery board 23-1 where the cell module C1 is arranged, it can be seen that the route heading from the arrangement position of the cell module C1 to the arrangement position of the cell module C4 as depicted by the directed side L11, and heading from the arrangement position of the cell module C4 to the arrangement position of the cell module C1 as depicted by a directed side L21 is the shortest route (the shortest closed route).

In other words, it can be seen that the rearrangement can be completed by exchanging the cell module C1 and the cell module C4.

Next, since the movement destinations of the cell module C1 and the cell module C4 have been determined, the directed sides L11, L12, and L21 to L23 of which the start point or the end point is the arrangement position (the first node) of the cell module C1 or the arrangement position (the fourth node) of the cell module C4 are all excluded (excluded from the examination target).

FIG. 8 is a diagram (Part 2) for describing the rearrangement destination setting sequence.

FIG. 8 illustrates a state in which the directed sides L11, L12, and L21 to L23 having no need for the examination are excluded from the state of FIG. 7.

Next, the rearrangement destination of the cell module C2 at the current arrangement position (a second node) is obtained. As the candidates of the rearrangement destination of the cell module C2, there are indicated effective sides L31 and L32 toward the arrangement position (a seventh node) of the cell module C7 and the arrangement position (an eighth node) of the cell module C8.

In this case, the cell module C7 and the cell module C8 are cell modules to be rearranged to the battery board 23-1 where the cell module C2 is arranged. Therefore, it can be seen that the route corresponding to the directed side L31 heading from the arrangement position of the cell module C2 to the arrangement position of the cell module C7 and the route corresponding to the directed side L32 heading from the arrangement position of the cell module C2 to the arrangement position of the cell module C8 both become the shortest routes.

Therefore, there is no problem in selecting any one of both routes. However, for example, in a case where two cell modules are exchanged, the first processed one is selected, and the route heading from the arrangement position of the subject cell module C7 to the arrangement position of the cell module C2 is selected as the shortest route.

Next, since the movement destinations of the cell module C2 and the cell module C7 have been determined, the directed sides L31, L32, L41, L42, and L51 of which the start point or the end point are the arrangement position (the second node) of the cell module C2 or the arrangement position (the seventh node) of the cell module C7 are all excluded (excluded from the examination target).

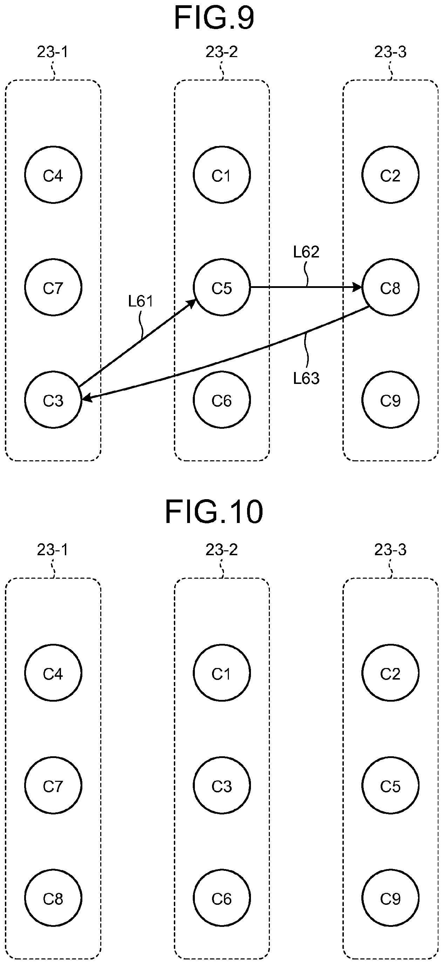

FIG. 9 is a diagram (Part 3) for describing the rearrangement destination setting sequence.

Subsequently, the rearrangement destinations of the cell module C3, the cell module C5, and the cell module C8 of which the rearrangement positions are not yet determined are obtained. As illustrated in FIG. 9, a directed side L61 heading from the arrangement position (a third node) of the cell module C3 to the arrangement position (a fifth node) of the cell module C5, a directed side L62 heading from the arrangement position (the fifth node) of the cell module C5 to the arrangement position (an eighth node) of the cell module C8, and a directed side L63 heading from the arrangement position (the eighth node) of the cell module C8 to the arrangement position (the third node) of the cell module C3 are left, and the routes are the shortest routes.

In other words, it can be seen that the rearrangement is completed by moving the cell module C3 to the arrangement position of the cell module C5, the cell module C5 to the arrangement position of the cell module C8, and the cell module C8 to the arrangement position of the cell module C3.

FIG. 10 is a diagram for describing the arrangement positions of the cell modules after the rearrangement is completed.

According to the sequence as described above, the rearrangement of the cell modules is completed, the cell modules having a higher performance value are arranged in the battery board 23-1 as illustrated in FIG. 10, the cell modules having a lower performance value are arranged in the battery board 23-3, and the remaining cell modules are arranged in the battery board 23-2.

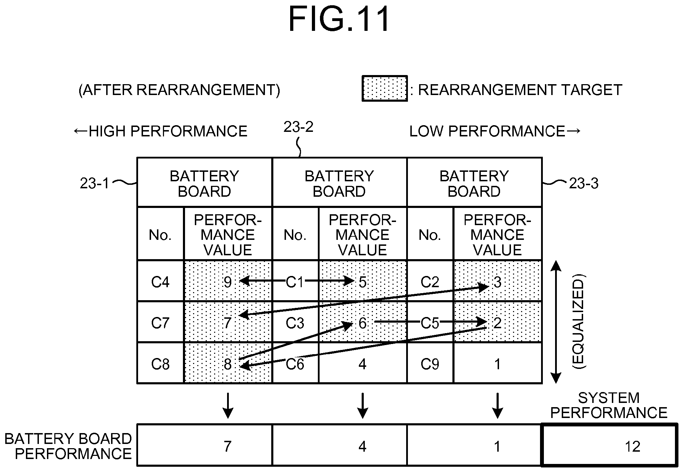

FIG. 11 is a diagram for describing the performance of the battery board unit after the cell modules are rearranged.

As a result, even though there is a relatively large difference in the performance value between the battery boards 23-1 to 23-3 as illustrated in FIG. 11, the difference in the performance value between three cell modules in each of the battery boards 23-1 to 23-3 is small.

As a result, the performance value of the battery board unit 21-1 becomes 12, and thus it can be seen that the performance value is improved compared to the performance value (= 6) before the rearrangement.

According to the rearrangement sequence described above, when a service person actually exchanges the cell modules after the rearrangement way of the cell modules is determined, the exchange work may be supported by displaying the exchange sequence illustrated in FIGS. 7 to 10 in a portable terminal or printing out the sequence as a printed product.

In addition, after all the exchange work is completed, it is examined whether the rearrangement of each of the battery modules is correctly performed, for example, using any one of methods described below.
(1) Unique ID information is recorded (in a storage unit in the CMU) for each cell module, and an interface for reading out the ID information from the outside is prepared. An examination is performed to check whether the rearrangement is correctly performed by inquiring the ID information before and after the rearrangement of each of the battery modules.
(2) In a case where the unique ID information is not assigned to the battery module, a degradation diagnosis such as the internal resistance is implemented again after the rearrangement of each of the battery modules, and it is examined whether a deviation (variation) of the degradation state in the battery units (a battery module group connected in series) is minimized (or reduced within an allowable range).

It is possible to efficiently implement maintenance work for maintaining the performance of the storage battery system by supplying the rearrangement sequence method described above and a function such as the presentation of the exchange sequence and an automatic examination after the rearrangement.

As described above, according to the storage battery system equipped with the storage battery devices to which the embodiment is applied, a work space, a work labor, and work hour can be saved in the rearrangement work of the battery modules.

Furthermore, the capacity of each storage battery device can be effectively used, an effective life span of the storage battery system is achieved, and an operation cost can be reduced. In addition, the storage battery system can be operated for a long term.

While certain embodiments have been described, these embodiments have been presented by way of example, and are not intended to limit the scope of the invention. Indeed, the novel embodiments described herein may be embodied in a variety of other forms; furthermore, various omissions substitutions and changes in the form of the embodiments described herein may be made without departing from the spirit of the inventions. The accompanying claims and their equivalents are intended to cover such forms or modifications as would fall within the scope and spirit of the inventions.

For example, the above description has been made by employing the configuration in which the host control device 6 performs the rearrangement process of the cell modules, but the rearrangement process may be performed by the storage battery controller 5 or the PCS 12.

In addition, the above description has been made about the configuration in which the cell module having a higher performance value is arranged in the battery board 23-1, the cell module having a lower performance value is arranged in the battery board 23-3, and the remaining cell modules are arranged in the battery board 23-2. However, the cell modules may be arranged in any battery board based on the performance value.

In addition, the above description has been made about the configuration in which the arrangement position of the cell module is not considered in the battery boards 23-1 to 23-M. However, since the temperature of the battery tends to be high as it goes to the upper portion in the battery boards 23-1 to 23-M, the rearrangement position may be set in consideration of this property.

## Claims

1. A storage battery device in which a plurality of battery boards are connected in parallel, the battery board including a plurality of cell modules connected in series, and the cell module including a battery cell, comprising:
a performance value acquisition unit that acquires a performance value of the cell module; and
an information generator that generates rearrangement information, the rearrangement information being information for performing rearrangement of the cell module between the plurality of battery boards based on the acquired performance value of the cell module to reduce a variation in the performance value of the cell module after being rearranged in one battery board than before being rearranged.

2. The storage battery device according to claim 1, further comprising:
an information presentation unit that presents the generated rearrangement information.

3. The storage battery device according to claim 1,
wherein the information generator generates the rearrangement information by a shortest closed route search using a directed graph, the cell module is set as a node and a directed side for specifying a rearrangement position is set to a route in the directed graph.

4. The storage battery device according to claim 1,
wherein the information generator sets a rank to the cell module based on a variation in the performance value of the cell module, and sequentially assigns the cell module to the plurality of battery boards according to the rank.

5. A storage battery system comprising:
a storage battery device in which a plurality of battery boards are connected in parallel, the battery board including a plurality of cell modules connected in series, and the cell module including a battery cell; and
a control device that controls the storage battery device,
wherein the control device includes
a performance value acquisition unit that acquires a performance value of the cell module from the storage battery device, and
an information generator that generates rearrangement information, the rearrangement information being for performing rearrangement of the cell module between the plurality of battery boards based on the acquired performance value of the cell module to reduce a variation in the performance value of the cell module after being rearranged in one battery board than before being rearranged.

6. The storage battery system according to claim 5,
wherein the control device includes an information presentation unit that presents the generated rearrangement information.

7. The storage battery system according to claim 5,
wherein the information generator generates the rearrangement information by a shortest closed route search using a directed graph, the cell module is set as a node and a directed side for specifying a rearrangement position is set to a route in the directed graph.

8. A method performed in a storage battery device in which a plurality of battery boards are connected in parallel, the battery board including a plurality of cell modules connected in series, and the cell module including a battery cell, comprising:
acquiring a performance value of the cell module;
generating rearrangement information, the rearrangement information being for performing rearrangement of the cell module between the plurality of battery boards based on the acquired performance value of the cell module to reduce a variation in the performance value of the cell module after being rearranged in one battery board than before being rearranged; and
presenting the generated rearrangement information.

9. A program for causing a computer to control a storage battery device in which a plurality of battery boards are connected in parallel, the battery board including a plurality of cell modules connected in series, and the cell module including a battery cell,
wherein the computer functions as
a unit of acquiring a performance value of the cell module,
a unit of generating rearrangement information, the rearrangement information being for performing rearrangement of the cell module between the plurality of battery boards based on the acquired performance value of the cell module to reduce a variation in the performance value of the cell module after being rearranged in one battery board than before being rearranged, and
a unit of presenting the generated rearrangement information.

10. The program according to claim 9,
wherein the unit of generating the rearrangement information generates the rearrangement information by a shortest closed route search using a directed graph, the cell module is set as a node and a directed side for specifying a rearrangement position is set to a route in the directed graph.
